# EUROPÄISCHE PATENTSCHRIFT

(11) **EP 0 994 485 B1**
(45) Veröffentlichungstag und Bekanntmachung des Hinweises auf die Patenterteilung: **19.01.2005**
(21) Anmeldenummer: 99114654.9
(22) Anmeldetag: 27.07.1999
(51) Int. Cl.: G11C 7/16

(54) **Vorrichtung und Verfahren zum digitalen Aufzeichnen eines analogen Audiosignals in einem digitalen Speicher**
Device and method for digital recording of an analog audio signal in a digital memory
Dispositif et méthode pour l'enregistrement digital d'un signal audio analogique dans une mémoire digitale

(30) Priorität: 13.10.1998 DE 19847015
(43) Veröffentlichungstag der Anmeldung: 19.04.2000
(73) Patentinhaber: ROBERT BOSCH GMBH, 70442 Stuttgart (DE)
(72) Erfinder: Lausen, Reinhard, 31162 Bad Salzdetfurth (DE)

(56) Entgegenhaltungen:
- DE-A- 3 807 597
- US-A- 5 392 381
- PATENT ABSTRACTS OF JAPAN vol. 1996, no. , 29. November 1996 (1996-11-29) & JP 08 195805 A (TOSHIBA CORP), 30. Juli 1996 (1996-07-30)

## Beschreibung

### Technisches Gebiet

Die Erfindung betrifft ein Verfahren zum digitalen Aufzeichnen eines analogen Audiosignals mit einer ersten vorbestimmten Datenrate als erste Audiodaten in einen digitalen Speicher, gemäß dem Oberbegriff des Anspruchs 1. Die Erfindung betrifft ferner eine Vorrichtung mit einem ersten Analog/Digital-Wandler und einem ersten Digital/Analog-Wandler, welche mit einem digitalen Speicher verbunden sind, zum digitalen Aufzeichnen eines analogen Audiosignals mit einer ersten vorbestimmten Datenrate als erste Audiodaten in den digitalen Speicher, gemäß dem Oberbegriff des Anspruchs 4.

### Stand der Technik

Es sind Rundfunkempfänger mit einer Einrichtung zur Aufzeichnung und Wiedergabe von Verkehrsfunkdurchsagen bekannt, wobei in einem digitalen Speicher Daten von einer oder mehreren Durchsagen speicherbar und beliebig oft abrufbar sind. Dieser Speicher hat jedoch eine vorbestimmte Größe bzw. Kapazität und kann daher nur eine begrenzte Datenmenge aufnehmen. Nach Aufzeichnung von beispielsweise vier Minuten ist der Speicher vollständig beschrieben und eine Durchsage, welche länger als diese vier Minuten dauert, ist somit nicht vollständig abspeicherbar, so dass ein Teil der Durchsage verloren geht. Bei einem späteren abhören der Durchsage fehlt dieser über vier Minuten hinausgehende Teil, was unkomfortabel und unzweckmäßig ist.

Es wurde daher bereits vorgeschlagen, z.B. in JP-A-08 195 805, ab einem vorbestimmten Belegungszustand des Speichers eine Datenrate bzw. Abtastfrequenz für eine Aufzeichnung der Verkehrsfunkdurchsage zu reduzieren. Der oben erwähnte Speicher mit vier Minuten Aufnahmekapazität wird dabei zur Hälfte mit herkömmlicher Datenrate beschrieben. Eine weiter Aufzeichnung mit Beschreiben der zweiten Hälfte des Speichers erfolgt dann mit entsprechend reduzierter Datenrate. Diese zweite Hälfte des Speichers, mit einer Aufnahmezeit von 120 Sekunden bei herkömmlicher Datenrate, hätte dann beispielsweise bei einem Beschreiben mit halbierter Datenrate eine Aufnahmezeit von 240 Sekunden. Nachteilig ist hierbei jedoch, dass die Reduktion der Datenrate zu einer entsprechenden Verminderung einer Wiedergabequalität der Aufzeichnung führt, so dass immer die zuletzt aufgenommene Verkehrsfunkdurchsage eine erheblich verminderte Wiedergabequalität aufweist. Die Wiedergabequalität der vorher aufgenommenen Durchsagen ist jedoch von üblicher Güte.

### Darstellung der Erfindung, Aufgabe, Lösung, Vorteile

Es ist Aufgabe der vorliegenden Erfindung, eine verbessertes Verfahren und eine verbesserte Vorrichtung der obengenannten Art zur Verfügung zu stellen, welche die obengenannten Nachteile beseitigt und eine bessere Ausnutzung eines Speichers zum Aufzeichnen von Verkehrsfunkdurchsagen erlauben.

Diese Aufgabe wird durch ein Verfahren der o.g. Art mit den in Anspruch 1 gekennzeichneten Merkmalen und durch eine Vorrichtung der o.g. Art mit den in Anspruch 4 gekennzeichneten Merkmalen gelöst.

Dazu ist es bei einem Verfahren der o.g. Art erfindungsgemäß vorgesehen, dass nach der Aufzeichnung die ersten Audiodaten zu zweiten Audiodaten mit einer zweiten Datenrate konvertiert und in einen anderen Bereich des Speichers abgespeichert werden, wobei die zweite Datenrate niedriger ist als die erste Datenrate.

Dies hat den Vorteil, dass bei vorgegebener Speicherkapazität längere Aufzeichnungszeiten erzielt werden, wobei immer jeweils die letzte Aufzeichnung mit optimaler Wiedergabequalität vorliegt.

Vorzugsweise Weitergestaltungen des Verfahrens sind in den Ansprüchen 2 und 3 beschrieben.

In einer besonders bevorzugten Ausführungsform werden zum Konvertieren der ersten Audiodaten in die zweiten Audiodaten die ersten Audiodaten analog wiedergegeben und mit der zweiten Datenrate digital abgetastet.

Zum Erzielen einer größtmöglichen Aufzeichnungsdauer für eine nachfolgende Aufzeichnung wird in besonders vorteilhafter Weise nach der Konvertierung derjenige Speicherbereich des digitalen Speichers, in dem die ersten Audiodaten abgespeichert sind, für ein erneutes Beschreiben freigegeben.

Ferner ist es bei einer Vorrichtung der o.g. Art erfindungsgemäß vorgesehen, dass die Vorrichtung zusätzlich eine Einrichtung zum Auslesen der ersten Audiodaten aus dem digitalen Speicher nach der Aufzeichnung, konvertieren dieser in zweite Audiodaten mit einer zweiten Datenrate und Abspeichern der zweiten Audiodaten in einen anderen Speicherbereich des digitalen Speichers als die ersten Audiodaten aufweist, wobei die zweite Datenrate niedriger ist als die erste Datenrate.

Dies hat den Vorteil, dass bei vorgegebener Speicherkapazität längere Aufzeichnungszeiten erzielt werden, wobei immer jeweils die letzte Aufzeichnung mit optimaler Wiedergabequalität vorliegt.

Vorzugsweise Weitergestaltungen der Vorrichtung sind in den Ansprüchen 5 und 6 beschrieben.

In einer besonders bevorzugten Ausführungsform weist die Einrichtung folgendes auf, einen zweiten Analog/Digital-Wandler und einen zweiten Digital/Analog-Wandler, wobei ein Eingang des zweiten Digital/Analog-Wandlers mit dem digitalen Speicher, ein Ausgang des zweiten Digital/Analog-Wandlers mit einem Eingang des zweiten Analog/Digital-Wandlers und ein Ausgang des zweiten Analog/Digital-Wandlers mit dem digitalen Speicher verbunden ist, wobei der zweite Analog/Digital-Wandler mit der zweiten Datenrate abtastet, so dass die ersten Audiodaten nach Durchlaufen des zweiten Digital/Analog-Wandlers und des zweiten Analog/Digitalwandlers mit der zweiten Datenrate im digitalen Speicher abspeicherbar sind. Hierbei ist es besonders vorteilhaft, dass die Konvertierung intern in der Vorrichtung und unbemerkt von einem Benutzer erfolgt sowie gleichzeitig sofort wieder eine weitere Aufzeichnung eines Audiosignal erfolgen kann.

Die Vorrichtung ist beispielsweise ein Rundfunkempfänger, insbesondere ein RDS-(Radio-Daten-System)-Rundfunkempfänger.

### Kurze Beschreibung der Zeichnungen

Nachstehend wird die Erfindung anhand der beigefügten Zeichnungen näher erläutert. Diese zeigen in
- Fig. 1: ein Blockschaltbild einer bevorzugte Ausführungsform einer erfindungsgemäßen Vorrichtung,
- Fig. 2: ein erstes Speicherbelegungsschema des digitalen Speichers vor einer Aufzeichnung,
- Fig. 3: ein zweites Speicherbelegungsschema des digitalen Speichers nach einer ersten Aufzeichnung,
- Fig. 4: ein drittes Speicherbelegungsschema des digitalen Speichers nach einer ersten Konvertierung
- Fig. 5: ein viertes Speicherbelegungsschema des digitalen Speichers nach einer zweiten Aufzeichnung und
- Fig. 6: ein fünftes Speicherbelegungsschema des digitalen Speichers nach einer anderen zweiten Aufzeichnung.

### Bester Weg zur Ausführung der Erfindung

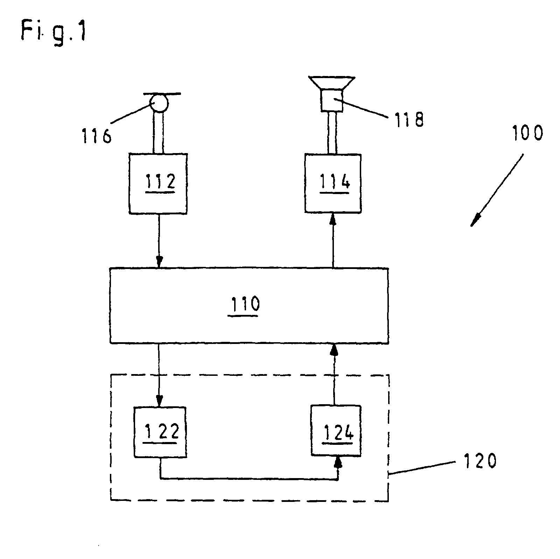

Die in Figur 1 dargestellte bevorzugte Ausführungsform einer erfindungsgemäßen Vorrichtung 100 umfasst einen digitalen Speicher 110, einen ersten Analog/Digital-Wandler 112 und einen ersten Digital/Analog-Wandler 114. Über ein Mikrofon 116 gelangt ein analoges Audiosignal zum ersten Analog/Digital-Wandler 112, weicher dieses mit einer ersten vorbestimmten Datenrate abtastet und entsprechende Audiodaten in den digitalen Speicher 110 schreibt. Der erste Digital/Analog-Wandler 114 dient zur Wiedergabe von aufgezeichneten, im digitalen Speicher 110 gespeicherten Audiodaten über einen Lautsprecher 118. Das Mikrofon 116 ist lediglich beispielhaft dargestellt, statt dessen ist dem Eingang des ersten Analog/Digital-Wandlers 112 auch direkt ein analoges NF-Signal zuführbar, beispielsweise aus einem Empfangsteil eines nicht dargestellten Rundfunkempfängers.

Nach einer Aufzeichnung eines analogen Signals liegen erste Audiodaten in dem Speicher 110 mit einer ersten vorbestimmten Datenrate vor. Die Datenrate bzw. Abtastfrequenz bestimmt eine Menge an abzuspeichernden Audiodaten, wobei eine größere Datenrate eine größere Menge an Audiodaten erzeugt und umgekehrt. Je größer dabei die Datenrate ist, desto höher ist eine spätere Wiedergabequalität über den Lautsprecher 118.

Die mit der ersten Datenrate abgespeicherten ersten Audiodaten werden von einer zusätzlichen Einrichtung 120 in zweite Audiodaten mit einer zweiten Datenrate konvertiert. Hierbei ist die zweite Datenrate niedriger als die erste Datenrate, so dass die zweiten Audiodaten ein geringeres Datenvolumen umfassen als die ersten Audiodaten. Die Einrichtung 120 umfasst einen zweiten Digital/Analog-Wandler 122 und einen zweiten Analog/Digital-Wandler 124. Ein Eingang des zweiten Digital/Analog-Wandlers 122 ist mit dem digitalen Speicher 110, ein Ausgang des zweiten Digital/Analog-Wandlers 122 ist mit einem Eingang des zweiten Analog/Digital-Wandlers 124 und ein Ausgang des zweiten Analog/Digital-Wandlers 124 ist mit dem digitalen Speicher 110 verbunden, wobei der zweite Analog/Digital-Wandler 124 mit der zweiten Datenrate abtastet, so dass die ersten Audiodaten nach Durchlaufen des zweiten Digital/Analog-Wandlers 122 und des zweiten Analog/Digitalwandlers 124 mit der zweiten Datenrate im digitalen Speicher 110 und damit mit geringerem Speicherbedarf abspeicherbar sind.

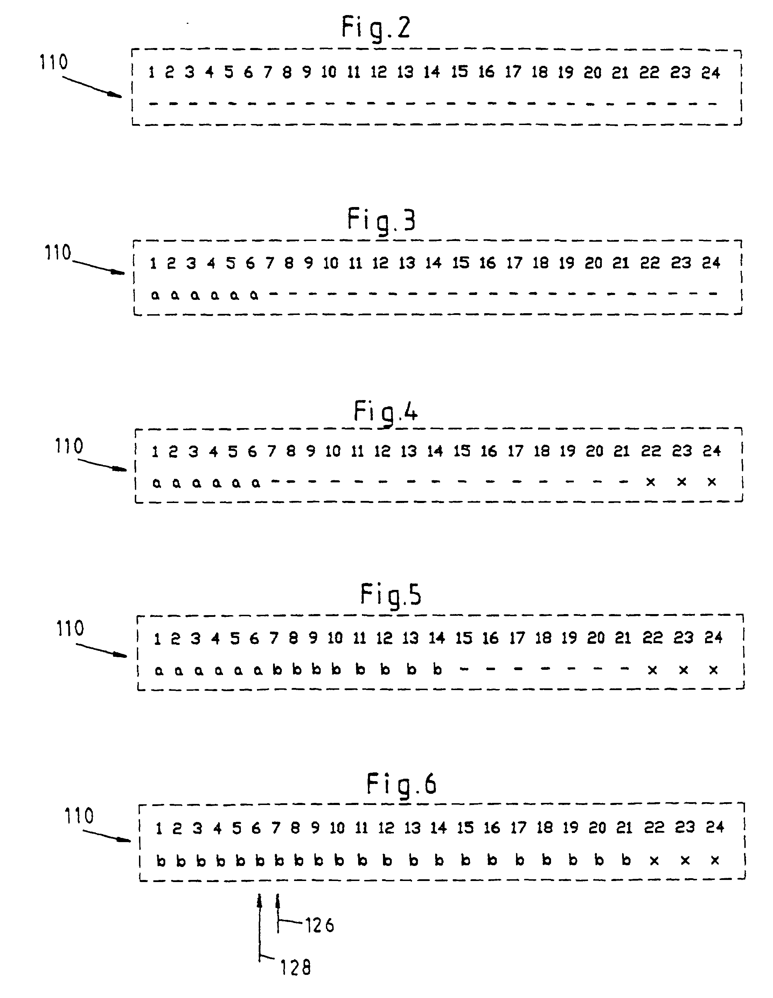

Der Speicher 110 hat ein festes, vorbestimmtes Speichervolumen, welches bei der ersten Datenrate einer ersten vorbestimmten Aufzeichnungsdauer entspricht. Nachfolgend wird unter Bezugnahme auf die Figuren 2 bis 6 das erfindungsgemäße Verfahren erläutert, welches bei konstanter Speicherkapazität des Speichers 110 eine Erhöhung der Aufzeichnungsdauer erzielt, wobei gleichzeitig jeweils die letzte Aufzeichnung mit optimaler Wiedergabequalität abrufbar ist.

Die Fig. 2 bis 6 zeigen jeweils ein Speicherbelegungsschema des digitalen Speichers 110 mit Speicherzellen bzw. -adressen 1 bis 24, wobei ein "." eine unbelegte Speicherzelle kennzeichnet, "a" mit einer ersten Datenrate aufgezeichnete erste Audiodaten einer ersten Aufzeichnung repräsentiert, "x" konvertierte zweiten Audiodaten mit zweiter Datenrate repräsentiert und "b" mit einer ersten Datenrate aufgezeichnete erste Audiodaten einer zweiten nachfolgenden Aufzeichnung repräsentiert.

Die erfindungsgemäße Vorrichtung 100 wird eingeschaltet und der Speicher 110 ist zunächst leer (Fig. 2). Danach erfolgt eine Aufzeichnung eines analogen Audiosignals, wie beispielsweise einer Verkehrsfunkdurchsage, wonach sich die ersten Audiodaten "x" in den Speicherzellen 1 bis 6 befinden (Fig. 3). Am Ende der Aufzeichnung erfolgt, beispielsweise automatisch von der Einrichtung 120 (Fig. 1) ausgelöst, eine interne Wiedergabe des ersten Audiosignals der Speicheradressen 1 bis 6 über den zweiten Digital/Analog-Wandler 122. Dessen analoges Ausgangssignal wird dem zweiten Analog/Digital-Wandler zugeführt, welcher dieses mit der zweiten Datenrate abtastet und im Speicher 110 als zweite Audiodaten "x" an einem anderen Speicherbereich, nämlich in den Speicheradressen 22 bis 24, abspeichert. Da die zweite Datenrate niedriger ist als die erste Datenrate ergibt sich für die zweiten Audiodaten "x" ein niedrigeres Datenvolumen, so dass entsprechend weniger Speicherplätze benötigt werden. Mit anderen Worten wurden die ersten Audiodaten "a" komprimiert. Jedoch ergibt sich bei einer Wiedergabe der Audiodaten "x" eine entsprechend verringerte Wiedergabequalität. Die Speicheradresse, an der die Speicherung der zweiten, komprimierten Audiodaten "x" beginnen muss, um genau bis ans Ende des Speichers 120 zu gelangen, kann von der Einrichtung 120 ermittelt werden, da die Länge der Aufzeichnung und damit der Speicherbedarf bei Abtasten mit der zweiten Datenrate berechenbar ist.

Die erste Aufzeichnung "a" der Speicheradressen 1 bis 6 ist nunmehr mit verringerter Datenrate in Speicheradressen 22 bis 24 gespeichert. Die Audiodaten "a" der ersten Aufzeichnung sind noch vorhanden, die Speicheradressen 1 bis 6 werden jedoch für eine weitere Aufzeichnung frei gegeben. Ein zweite, nachfolgende Aufzeichnung eines analogen Audiosignals erfolgt dann als Audiodaten "b" ab der Speicheradresse 7. Fig. 5 zeigt eine erste Variante, bei der die zweite Aufzeichnung noch nicht so lange war, dass die Speicheradressen 1 bis 6 benötigt wurden. Die ersten Audiodaten "b" der zweiten Aufzeichnung befinden sich in den Speicheradressen 7 bis 14. Weitere Audiosignale können als weitere erste Audiodaten in den Speicheradressen 15 bis 21 und 1 bis 6 gespeichert werden.

Fig. 6 zeigt einen zweiten Fall für eine zweite Aufzeichnung eines Audiosignals mit längerer Zeitdauer. Hier werden für die Speicherung in Speicher 110 die Speicheradressen 7 bis 21 und 1 bis 6 benötigt. Die ersten Audiodaten "b" der zweiten Aufzeichnung beginnen somit bei der Speicheradresse 7, wie mit Pfeil 126 angedeutet, setzen sich fort ab der Speicheradresse 1 und enden bei der Speicheradresse 6, wie mit Pfeil 128 angedeutet. Die ersten Audiodaten der zweiten Aufzeichnung sind mit der ersten Datenrate abgespeichert, so dass bei einer Wiedergabe der zweiten Aufzeichnung eine optimale Wiedergabequalität vorliegt.

Nach jeder Aufzeichnung erfolgt, wie voranstehend beschrieben, eine interne Wiedergabe der vorherigen Aufzeichnung bei gleichzeitiger Aufzeichnung mit verringerter Datenrate. Hierdurch wird ein Teil des Speichers für weitere Aufzeichnungen freigegeben.

Soll während der internen Wiedergabe/Aufzeichnung eine weiteres Audiosignal aufgezeichnet werden, so ist das wegen der zweifach vorhandenen Schaltungsteile mit Wandlern 112, 114 zur externen Aufzeichnung/Wiedergabe einerseits und Wandlern 122, 124 zur internen Wiedergabe/Aufzeichnung andererseits sowie den bekannten Start- und Stop-Speicheradressen der jeweiligen Aufzeichnungen und den noch freien Speicheradressen gleichzeitig möglich.

Durch eine entsprechende Verwaltung der Start/Stop-Speicheradressen können mehrere Durchsagen im Speicher 110 gehalten werden, wobei zumindest die jeweils aktuelle, letzte Durchsage mit bestmöglicher Qualität abrufbar bzw. abspielbar ist.

In besonders bevorzugter Weise ist die erfindungsgemäße Vorrichtung 100 in einen Rundfunkempfänger zur Aufzeichnung und Wiedergabe von Verkehrsfunkdurchsagen implementiert, wobei hier ggf. lediglich die zusätzliche Einrichtung 120 vorzusehen ist.

## Patentansprüche

1. Verfahren zum digitalen Aufzeichnen eines analogen Audiosignals mit einer ersten vorbestimmten Datenrate als erste Audiodaten in einen digitalen Speicher,
**dadurch gekennzeichnet, dass**
nach der Aufzeichnung die ersten Audiodaten zu zweiten Audiodaten mit einer zweiten Datenrate konvertiert und in einen anderen Bereich des Speichers abgespeichert werden, wobei die zweite Datenrate niedriger ist als die erste Datenrate.

2. Verfahren nach Anspruch 1,
**dadurch gekennzeichnet, dass**
zum Konvertieren der ersten Audiodaten in die zweiten Audiodaten die ersten Audiodaten analog wiedergegeben und mit der zweiten Datenrate digital abgetastet werden.

3. Verfahren nach Anspruch 1 oder 2,
**dadurch gekennzeichnet, dass**
nach der Konvertierung derjenige Speicherbereich des digitalen Speichers, in dem die ersten Audiodaten abgespeichert sind, für ein erneutes Beschreiben freigegeben wird.

4. Vorrichtung (100) mit einem ersten Analog/Digital-Wandler (112) und einem ersten Digital/Analog-Wandler (114), welche jeweils mit einem digitalen Speicher (110) verbunden sind, zum digitalen Aufzeichnen eines analogen Audiosignals mit einer ersten vorbestimmten Datenrate als erste Audiodaten in den digitalen Speicher,
**dadurch gekennzeichnet, dass**
die Vorrichtung (100) zusätzlich eine Einrichtung (120) zum Auslesen der ersten Audiodaten aus dem digitalen Speicher (110) nach der Aufzeichnung, zum Konvertieren dieser in zweite Audiodaten mit einer zweiten Datenrate und zum Abspeichern der zweiten Audiodaten in einen anderen Speicherbereich des digitalen Speichers (110) als die ersten Audiodaten aufweist, wobei die zweite Datenrate niedriger ist als die erste Datenrate.

5. Vorrichtung (100) nach Anspruch 4,
**dadurch gekennzeichnet, dass**
die Einrichtung (120) folgendes aufweist, einen zweiten Analog/Digital-Wandler (124) und einem zweiten Digital/Analog-Wandler (122), wobei ein Eingang des zweiten Digital/Analog-Wandlers (122) mit dem digitalen Speicher (110), ein Ausgang des zweiten Digital/Analog-Wandlers (122) mit einem Eingang des zweiten Analog/Digital-Wandlers (124) und ein Ausgang des zweiten Analog/Digital-Wandlers (124) mit dem digitalen Speicher (110) verbunden ist, wobei der zweite Analog/Digital-Wandler (124) mit der zweiten Datenrate abtastet, so dass die ersten Audiodaten nach Durchlaufen des zweiten Digital/Analog-Wandlers (122) und des zweiten Analog/Digitalwandlers (124) mit der zweiten Datenrate im digitalen Speicher (110) abspeicherbar sind.

6. Vorrichtung (110) nach Anspruch 5 oder 6,
**dadurch gekennzeichnet, dass**
die Vorrichtung (110) ein Rundfunkempfänger, insbesondere ein RDS-(Radio-Daten-System)-Rundfunkempfänger ist.

## Claims

1. Method for digitally recording an analogue audio signal at a first predetermined data rate as first audio data in a digital memory,
**characterized in that**
the recording is followed by the first audio data being converted into second audio data at a second data rate and being stored in another area of the memory, the second data rate being lower than the first data rate.

2. Method according to Claim 1,
**characterized in that**
the first audio data are converted into the second audio data by reproducing the first audio data in analogue form and digitally sampling them at the second data rate.

3. Method according to Claim 1 or 2,
**characterized in that**
the conversion is followed by that memory area of the digital memory in which the first audio data are stored being released for a fresh write operation.

4. Apparatus (100) having a first analogue/digital converter (112) and a first digital/analogue converter (114), which are respectively connected to a digital memory (110), for digitally recording an analogue audio signal at a first predetermined data rate as first audio data in the digital memory,
**characterized in that**
the apparatus (100) additionally has a device (120) for reading the first audio data from the digital memory (110) after the recording, for converting these data into second audio data at a second data rate and for storing the second audio data in a different memory area of the digital memory (110) from the first audio data, the second data rate being lower than the first data rate.

5. Apparatus (100) according to Claim 4,
**characterized in that**
the device (120) has the following: a second analogue/digital converter (124) and a second digital/analogue converter (122), where an input on the second digital/analogue converter (122) is connected to the digital memory (110), an output on the second digital/analogue converter (122) is connected to an input on the second analogue/digital converter (124), and an output on the second analogue/digital converter (124) is connected to the digital memory (110), where the second analogue/digital converter (124) samples at the second data rate, so that the first audio data, having passed through the second digital/analogue converter (122) and the second analogue/digital converter (124), can be stored in the digital memory (110) at the second data rate.

6. Apparatus (110) according to Claim 5 or 6,
**characterized in that**
the apparatus (110) is a broadcast radio receiver, particularly an RDS (Radio Data System) broadcast radio receiver.

## Revendications

1. Procédé pour l'enregistrement numérique d'un signal audio analogique avec un premier débit prédéfini en tant que premières données audio dans une mémoire numérique,
**caractérisé en ce qu'**
après l'enregistrement, les premières données audio sont converties en deuxièmes données audio avec un second débit et sont enregistrées dans une autre zone de la mémoire, le deuxième débit étant inférieur au premier.

2. Procédé selon la revendication 1,
**caractérisée en ce que**
pour convertir les premières données audio en deuxièmes données audio, les premières données audio sont reproduites de manière analogique et lues de manière numérique avec les deuxièmes données audio.

3. Procédé selon la revendication 1 ou 2,
**caractérisée en ce qu'**
après la conversion, la zone de mémoire correspondante de la mémoire numérique dans laquelle sont enregistrées les premières données audio est libérée pour un nouvel enregistrement.

4. Dispositif (100) doté d'un premier convertisseur analogique/numérique (112) et d'un premier convertisseur numérique/ànalogique (114) reliés respectivement par une mémoire numérique (110) afin d'assurer l'enregistrement numérique d'un signal audio analogique avec un premier débit prédéfini en tant que premières données audio dans la mémoire numérique,
**caractérisé en ce que**
le dispositif (100) comporte en plus un dispositif (120) pour lire les premières données audio à partir de la mémoire numérique (110) après l'enregistrement, pour les convertir en deuxièmes données audio avec un deuxième débit et pour enregistrer les deuxièmes données audio dans une autre zone de mémoire de la mémoire numérique (110) en tant que premières données audio, le deuxième débit étant inférieur au premier.

5. Dispositif (100) selon la revendication 4,
**caractérisé en ce que**
le dispositif (120) présente les éléments suivants : un deuxième convertisseur analogique/numérique (124) et un deuxième convertisseur numérique/analogique (122), une entrée du deuxième convertisseur numérique/analogique (122) étant reliée à la mémoire numérique (110), une sortie du deuxième convertisseur numérique/analogique (122) étant reliée à une entrée du deuxième convertisseur analogique/numérique (124) et une sortie du deuxième convertisseur analogique/numérique (124) étant reliée à la mémoire numérique (110), le deuxième convertisseur analogique/numérique (124) étant lu avec le deuxième débit de manière à ce que les premières données audio puissent être enregistrées dans la mémoire numérique (110) après avoir traversé le deuxième convertisseur numérique/analogique (122) et le deuxième convertisseur analogique/numérique (124) avec le deuxième débit.

6. Dispositif (110) selon la revendication 5 ou 6,
**caractérisé en ce que**
le dispositif (110) est un récepteur de radiodiffusion, notamment un récepteur de radiodiffusion à RDS (Radio Data System).
